Europäisches Patentamt

European Patent Office

Office européen des brevets

(11) Publication number: **0 109 081**
**A1**

(12) **EUROPEAN PATENT APPLICATION**

(21) Application number: **83111365.9**

(22) Date of filing: **14.11.83**

(51) Int. Cl.³: **H 03 F 3/343**

(30) Priority: **15.11.82 JP 200115/82**

(43) Date of publication of application: **23.05.84**
**Bulletin 84/21**

(84) Designated Contracting States: **DE FR GB**

(71) Applicant: **NEC CORPORATION, 33-1, Shiba 5-chome, Minato-ku, Tokyo 108 (JP)**

(72) Inventor: **Fujii, Akira, c/o NEC Corporation 33-1, Shiba 5-chome, Minato-ku Tokyo (JP)**

(74) Representative: **Vossius Vossius Tauchner Heunemann Rauh, Siebertstrasse 4 P.O. Box 86 07 67, D-8000 München 86 (DE)**

(54) **Bidirectional constant current driving circuit.**

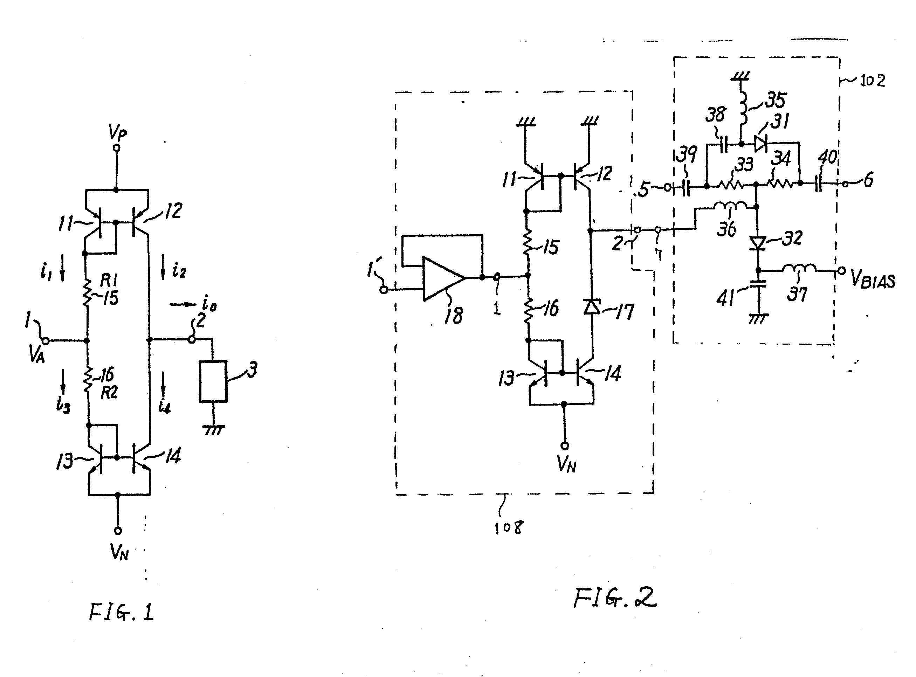

(57) The bidirectional constant current driving circuit has an input terminal (1), an output terminal (2) and first and second power supply terminals ($V_P$, $V_N$), for driving a load (3) coupled to the output terminal in response to an input signal ($V_A$) applied to the input terminal (1). The driving circuit comprises a first transistor (12) having a first electrode connected to the first power supply terminal ($V_P$); a second transistor (11) having a first electrode connected to the first power supply terminal ($V_P$), and second and third electrodes connected to a second electrode of the first transistor (11); a third transistor (14) having a first electrode connected to the second power supply terminal ($V_N$); a fourth transistor (13) having a first electrode connected to the second power supply terminal ($V_N$), and second and third electrodes connected to a second electrode of the third transistor (14). A first and a second resistor (15, 16) are serially connected between the third electrode of the second transistor (11) and that of the fourth transistor (13), the junction of the first and second resistors (15, 16) being connected to the input terminal (1). A coupling means couples the third electrodes of the first and third transistor (12, 14) to the output terminal (2), respectively. This circuit gives constant currents in both positive and negative directions (Fig. 1).

Our Ref.: S 696 EP
Case: P-7386

NEC Corporation
Tokyo

0109081

## Bidirectional Constant Current Driving Circuit

### Background of the Invention

The present invention relates to a bidirectional constant current driving circuit capable of driving variable attenuators and the like using PIN diodes with constant currents in both positive and negative directions.

Constant current driving circuits have been traditionally used for driving loads with constant currents irrespective of impedance variations of the loads, and one of typical such circuits is one to give a voltage to the base of a transistor to whose emitter is connected a resistor and thereby to drive a load connected to the collector thereof with a constant current. Such driving circuits are often used because of their simple structure, but they have the disadvantage of being able to provide currents in only one direction.

### Summary of the Invention

An object of the present invention, therefore, is to eliminate the above-mentioned disadvantage and to provide a bidirectional constant current circuit capable of giving constant currents in both positive and negative directions.

According to the present invention, there is provided a bidirectional constant current driving circuit having an input terminal, an output terminal and first and second power supply terminals, for driving a load coupled to the output terminal in response to an input signal applied to the input terminal. The driving circuit comprises first transistor means having a first electrode connected to the first power supply terminal; second transistor means having a first electrode connected to the first power supply terminal, and second and third electrodes connected to a second electrode of the first transistor means; third transistor means having a first electrode connected to the second power supply terminal; fourth transistor means having a first electrode connected to the second power supply terminal, and second and third electrodes connected to a second electrode of the third transistor means; first and second resistor means serially connected between the third electrode of the second transistor means and that of the fourth transistor means, the junction of the first and second resistor means being connected to the input terminal; and coupling means for coupling the third electrodes of the first and third transistor means to the output terminal, respectively.

Brief Description of Drawings

FIG. 1 is a circuit diagram illustrating one preferred embodiment of the bidirectional constant current driving circuitry according to the present invention;

FIG. 2 is a circuit diagram illustrating an example
in which the bidirectional constant current driving circuit
of FIG. 1 is applied to the driving of a high-frequency
variable attenuator using PIN diodes; and

FIG. 3 is a block diagram illustrating an example in
which the circuit of FIG. 2 is applied to a transmitting
power control circuit for a radio transmitter.


Preferred Embodiments of the Invention

FIG. 1 shows one preferred embodiment of the present
invention. The operation of the circuit of FIG. 1 will be
briefly described below. A control voltage fed to an input
terminal 1 is represented by $V_A$. If the base current is
ignored, the collector current il of a PNP transistor 11
will be

$$il = \frac{V_P - V_{BE1} - V_A}{R1}$$

where $V_{BE1}$ is the voltage between the emitter and base
electrodes of the PNP transistor 11, $V_P$ is the positive
power supply voltage and R1 is the resistance of a resistor 15.
Meanwhile, the collector current i3 of an NPN transistor 13
will be

$$i3 = \frac{V_A - V_N - V_{BE2}}{R2}$$

where $V_{BE2}$ is the voltage between the base and emitter
electrodes of the NPN transistor 13, $V_N$ is the negative power supply voltage and R2 is the resistance of a resistor 16. If the characteristics of PNP transistors 11 and 12 are matched, the collector current i2 of the PNP transistor 12 will be

$$i2 \simeq i1$$

and similarly, if the characteristics of NPN transistors 13 and 14 are matched, the collector current i4 of the NPN transistor 14 will be

$$i4 \simeq i3$$

Accordingly, the current i0 of an output current flowing to a load 3 will be

$$i0 = i2 - i4$$

$$\simeq i1 - i3$$

$$= \frac{V_P - V_{BE1} - V_A}{R1} - \frac{V_A - V_N - V_{BE2}}{R2}$$

$$= -V_A(\frac{1}{R2} + \frac{1}{R2}) + (\frac{V_P}{R1} + \frac{V_N}{R2}) + (\frac{V_{BE1}}{R1} - \frac{V_{BE2}}{R2})$$

If, for simplicity's sake, it is supposed that

$$R1 = R2$$

$$V_P + V_N = 0$$

$$V_{BE1} = V_{BE2}$$

then,

$$io \simeq -\frac{2}{R1}V_A$$

so that the output current is found to be proportional to the input control voltage $V_A$. Moreover, as is obvious from the circuit structure, the output current can be given in either direction, positive or negative. Furthermore, the terminal voltage of the load can be selected without adversely affecting the operation from a very wide range from what is extremely close to the positive power supply voltage to what is extremely close to the negative power supply voltage, unless the PNP transistor 12 or the NPN transistor 14 becomes saturated. The PNP transistor has an inverse conductive junction with respect to the conductive juction of the NPN transistor.

Next, FIG. 2 illustrates an example in which the bidirectional constant current of FIG. 1 is applied to the driving of a high-frequency variable attenuator using PIN diodes. In FIG. 2, the same reference numerals as in FIG. 1 represent respectively the same functions. A constant current driving circuit 108 consists of the circuit shown in FIG. 1, a Zener diode 17 and a buffer 18. A variable attenuator 102 is a generally known circuit, comprising PIN diodes 31 and 32, resistors 33 and 34, chokes 35 to 37 and capacitors 38 to 41. In this variable attenuator 102, the attenuation from an input terminal 5 to an output terminal 6 exhibits a characteristic to decrease when the current of the PIN diode 31 is increased and that of the PIN diode 32 is decreased, and to increase in the reverse case. In order to achieve a satisfactory temperature characteristic, it is desirable to apply a temperature-compensated constant voltage ($V_{BIAS}$) to this variable attenuator through the choke coil 37 and further to drive this variable attenuator with a constant current through the choke coil 36. Since this driving current requires both positive and negative directions depending on the extent of attenuation, the purpose can be achieved by the use of the bidirectional constant current driving circuit according to the present invention. Whereas the terminal voltage at the driving point, in the case of this circuit, is about -0.6 V, which is extremely close to the ground potential, this embodiment is highly economical because it can be a single-power supply circuit, with its positive power supply terminal being grounded.

In this preferred embodiment, the Zener diode 17 is inserted into the collector of the transistor 14 to decrease the collector loss of the transistor 14 and thereby to prevent the thermal balance between the transistors 13 and 14 from being too heavily disturbed. The control voltage is applied through the buffer 18 which consists of an operational amplifier of voltage-follower type. However, the Zener diode 17 and the buffer 18 are used only as required, and not indispensable for the present invention.

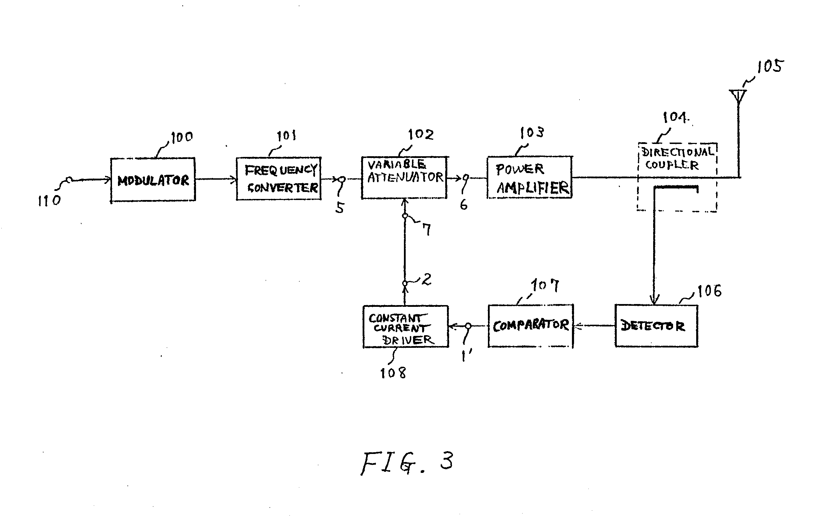

FIG. 3 illustrates an example in which the circuit of FIG. 2 is applied to a transmitting power control circuit for a radio transmitter. In FIG. 3, the same reference numerals as in FIG. 2 represent respectively the same functions. A modulator (an FM modulator, for example) 100 modulates a carrier wave with an input signal supplied to a terminal 110. The modulated carrier wave is frequency-converted by a frequency converter 101, and supplied to a power amplifier 103 through the variable attenuator 102. The output of the power amplifier 103 is sent out through a directional coupler 104 and an antenna 105. Further, a part of the output of the amplifier 103 is taken out of the directional coupler 104, level-detected by a detector 106, and compared with a reference level by a comparator 107, and the resultant differential voltage is supplied to an input terminal 1' of the constant current driving circuit 108, which controls the attenuation of the attenuator 102 according to said differential voltage to keep the output of the transmitter, i.e. that of the amplifier 103, at a constant level.

C L A I M S

1.  A bidirectional constant current driving circuit
    having an input terminal (1), an output terminal (2)
    and first and second power supply terminals $(V_P, V_N)$,
    for driving a load (3) coupled to said output terminal
    in response to an input signal $(V_A)$ applied to said
    input terminal (1), comprising:

    a)   first transistor means (12) having a first electrode
    connected to said first power supply terminal $(V_P)$;

    b)   second transistor means (11) having a first
    electrode connected to said first power supply terminal
    $(V_P)$, and second and third electrodes connected to a
    second electrode of said first transistor means (11);

    c)   third transistor means (14) having a first electrode
    connected to said second power supply terminal $(V_N)$;

    d)   fourth transistor means (13) having a first electrode
    connected to said second power supply terminal $(V_N)$,
    and second and third electrodes connected to a second
    electrode of said third transistor means (14);

    e)   first and second resistor means (15,16) serially
    connected between the third electrode of said second
    transistor means (11) and that of said fourth
    transistor means (13), the junction of said first and
    second resistor means (15,16) being connected to said
    input terminal (1); and

    f)   coupling means for coupling the third electrodes of
    said first and third transistor means (12,14) to said
    output terminal (2), respectively.

2. A bidirectional constant current driving circuit as claimed in Claim 1, wherein each of said first and second transistor means (12,11) has an inverse conductive junction structure with respect to the conductive junction structure of each of said third and fourth transistor means (14,13).

3. A bidirectional constant current driving circuit as claimed in Claim 1 or 2, wherein each of said first and second transistor means (12,11) comprises a PNP transistor, and each of said third and fourth transistor means (14,13) comprises an NPN transistor.

4. A directional constant current driving circuit as claimed in any one of Claims 1 to 3, wherein said coupling means includes a Zener diode (17) provided between said output terminal (2) and the third electrode of said third transistor means (14).

5. A directional constant current driving circuit as claimed in any of one Claims 1 to 4, wherein said first, second, third electrodes are emitter, base and collector electrodes, respectively.

FIG. 2

FIG. 1

MODULATOR 100

FREQUENCY CONVERTER 101

VARIABLE ATTENUATOR 102

POWER AMPLIFIER 103

DIRECTIONAL COUPLER 104

105

110

5

7

6

2

CONSTANT CURRENT DRIVER 108

COMPARATOR 107

DETECTOR 106

1'

FIG. 3

0109081

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 3) |
|---|---|---|---|
| X | US-A-4 267 521 (K. YOKOYAMA) <br> * Figure 1 * | 1-3,5 | H 03 F 3/343 |
| A | US-A-4 140 977 (RCA) <br><br> * Figure 2 * | | |
| A | NACHRICHTEN ELEKTRONIK, vol. 33, no. 12, December 1979, Heidelberg K. RUF "Leistungsregelung und Leistungsbilanz transistorisierter Sendeverstärker", pages 400-402 <br> * Page 400, figure 1 * | | |
| A | DE-B-2 600 594 (HITACHI) <br><br> * Figure 3 * | | TECHNICAL FIELDS SEARCHED (Int. Cl. 3) |
| A | DE-A-2 452 445 (RCA) <br><br> * Figure 3 * | | H 03 F 3/34 <br> H 03 F 3/343 <br> H 03 F 3/347 |

The present search report has been drawn up for all claims

| Place of search | Date of completion of the search | Examiner |
|---|---|---|
| BERLIN | 17-01-1984 | BREUSING J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82